# EUROPÄISCHE PATENTSCHRIFT

(11) **EP 1 412 139 B1**
(45) Veröffentlichungstag und Bekanntmachung des Hinweises auf die Patenterteilung: **09.01.2008**
(21) Anmeldenummer: 01994047.7
(22) Anmeldetag: 04.11.2001
(51) Int. Cl.: B25J 19/02, B25J 9/16, G01R 1/067, G01R 31/316, G01R 31/01

(54) **VORRICHTUNG ZUM ZIELGERICHTETEN BEWEGEN ELEKTRONISCHER BAUTEILE MIT EINEM SCHWENKSPIEGEL**
DEVICE FOR THE TARGETED DISPLACEMENT OF ELECTRONIC COMPONENTS, USING A PIVOTING MIRROR
DISPOSITIF POUR LE DEPLACEMENT CIBLE DE COMPOSANTS ELECTRONIQUES AU MOYEN D'UN MIROIR PIVOTANT

(30) Priorität: 10.11.2000 DE 20019096 U
(43) Veröffentlichungstag der Anmeldung: 28.04.2004
(73) Patentinhaber: IEF Werner GmbH, 78120 Furtwangen (DE)
(72) Erfinder: MEISSNER, Hans-Georg, 83233 Bernau (DE)
(74) Vertreter: Patentanwälte Westphal, Mussgnug & Partner
(86) Internationale Anmeldenummer: PCT/DE2001/004096
(87) Internationale Veröffentlichungsnummer: WO 2002/039801

(56) Entgegenhaltungen:
- EP-A- 0 812 662
- EP-A- 0 884 141
- US-A- 3 986 007
- US-A- 5 096 353
- US-A- 5 195 234
- US-A- 5 865 319

## Beschreibung

Die vorliegende Erfindung betrifft eine Vorrichtung zum zielgerichteten Bewegen von elektronischen Bauteilen mit den im Oberbegriff des Patentanspruchs 1 angegebenen Merkmalen.

Eine Vorrichtung zum zielgerichteten Bewegen von elektronischen Bauteilen ist beispielsweise in sogenannten "Chip-Handlern" erforderlich, in denen elektronische Bauteile auf einem Tablett angeliefert, von dort mittels einer Vorrichtung zum zielgerichteten Bewegen aufgenommen und von dieser Vorrichtung zum zielgerichteten Bewegen an einen Kontaktsockel herangeführt werden. Hinter dem Kontaktsockel befindet sich dort eine Prüfeinrichtung, welche während der Kontaktzeit zwischen dem elektronischen Bauteil und dem Kontaktsockel die elektrische Funktionsfähigkeit des zu prüfenden elektronischen Bauteils prüft.

Aus dem Stand der Technik geht nun eine Vorrichtung zum zielgerichteten Bewegen von elektronischen Bauteilen hervor, bei welcher vor der Herstellung des Kontaktes zwischen dem zu prüfenden elektronischen Bauteil und dem Kontaktsockel zumindest die korrekte Ausrichtung des elektronischen Bauteiles über eine separate Betrachtungsvorrichtung überprüft werden kann.

Diese aus dem Stand der Technik bekannte Vorrichtung zum zielgerichteten Bewegen von elektronischen Bauteilen weist insbesondere den Nachteil auf, daß sie die automatische Betrachtung der Lage, der Ausrichtung sowie der Beschaffenheit der Kontakte des Kontaktsockels nicht ermöglicht.

Für die automatische Betrachtung der Lage, der Ausrichtung sowie der Beschaffenheit der Kontakte des Kontaktsockels wäre dort vielmehr die aufwendige und teure Installation eines weiteren, auf den Kontaktsockel gerichteten Betrachtungssystems erforderlich.
Die Möglichkeit zur Betrachtung der Lage, der Ausrichtung sowie der Beschaffenheit der Kontakte des Kontaktsockels ist insbesondere unter dem Aspekt einer Optimierung der Kontaktierungsqualität zwischen dem zu prüfenden elektronischen Bauteil und dem Kontaktsockel wünschenswert.

US-A-5195234 (Pine et al.) offenbart eine Vorrichtung zum zielgerichteten Bewegen von elektronischen Bauteilen mit einem einzigen Kamera zur Betrachtung in zwei einander entgegenge setzten Richtungen.

Aufgabe der vorliegenden Erfindung ist daher die Bereitstellung einer Vorrichtung zum zielgerichteten Bewegen von elektronischen Bauteilen, welche mit einem einzigen, besonders einfach und kostengünstig herzustellenden und keine exakte Justage erfordernden Betrachtungssystem sowohl die Betrachtung der Kontaktseite der zu prüfenden elektronischen Bauteile als auch die Betrachtung der Kontakteinrichtung erlaubt.

Erfindungsgemäß wird diese Aufgabe bei einer gattungsgemäßen Vorrichtung durch die im kennzeichnenden Teil des Patentanspruchs 1 angegebenen Merkmale gelöst.

Besonders bevorzugte Ausführungsformen sind Gegenstand der Unteransprüche.

Einige Ausführungsbeispiele der Erfindung werden anhand der Figuren näher beschrieben. Es zeigen:

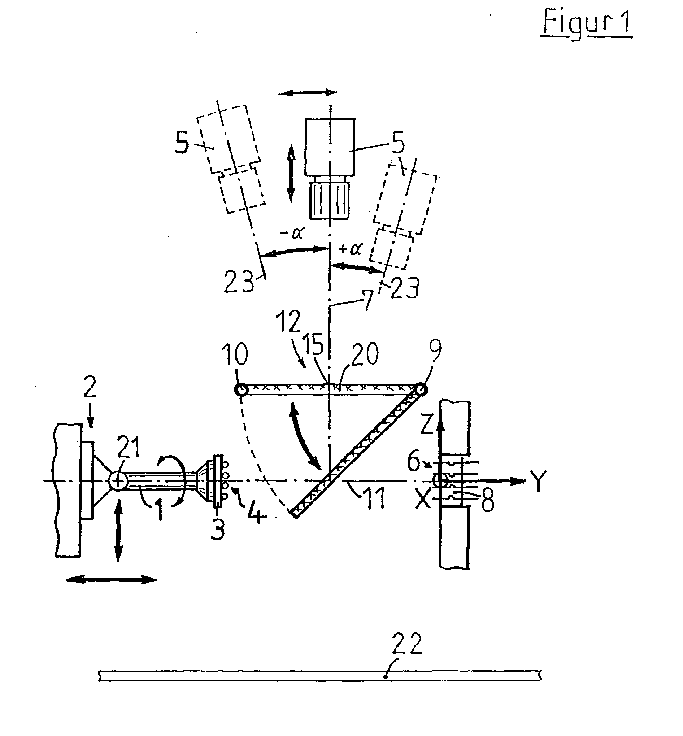

Figur 1 eine schematische Seitenansicht einer erfindungsgemäßen Vorrichtung zum zielgerichteten Bewegen elektronischer Bauteile mit einer in die optische Achse zwischen Handhabungseinrichtung und Kontakteinrichtung um eine kontakteinrichtungsseitige und eine bauteilseitige Drehachse einschwenkbaren Vorrichtung zur Reflexion, wobei hier die Vorrichtung zur Reflexion um die kontakteinrichtungsseitige Drehachse in die optische Achse zwischen der Handhabungseinrichtung und der Kontakteinrichtung eingeschwenkt ist;

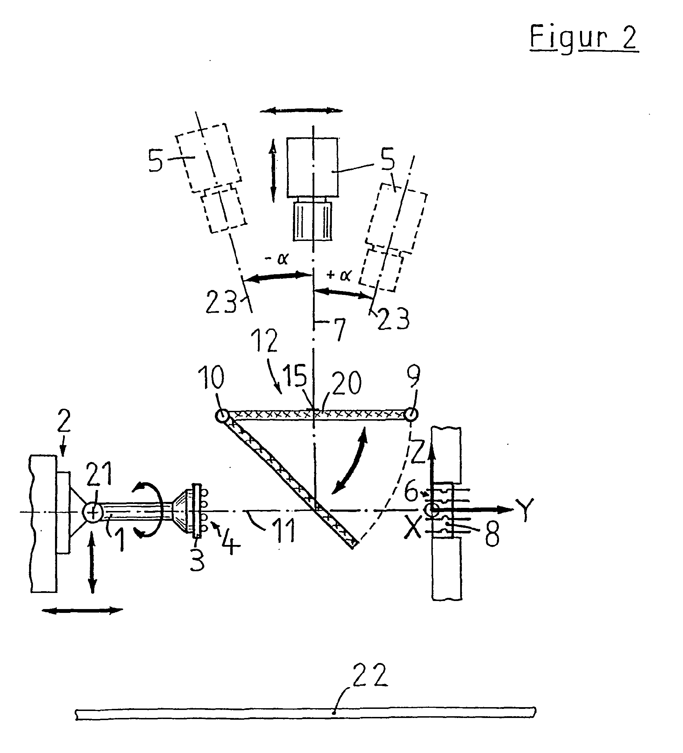

Figur 2 eine schematische Seitenansicht einer erfindungsgemäßen Vorrichtung zum zielgerichteten Bewegen elektronischer Bauteile mit einer in die optische Achse zwischen Handhabungseinrichtung und Kontakteinrichtung um eine kontakteinrichtungsseitige und eine bauteilseitige Drehachse einschwenkbaren Vorrichtung zur Reflexion, wobei hier die Vorrichtung zur Reflexion um die bauteilseitige Drehachse in die optische Achse zwischen der Handhabungseinrichtung und der Kontakteinrichtung eingeschwenkt ist;

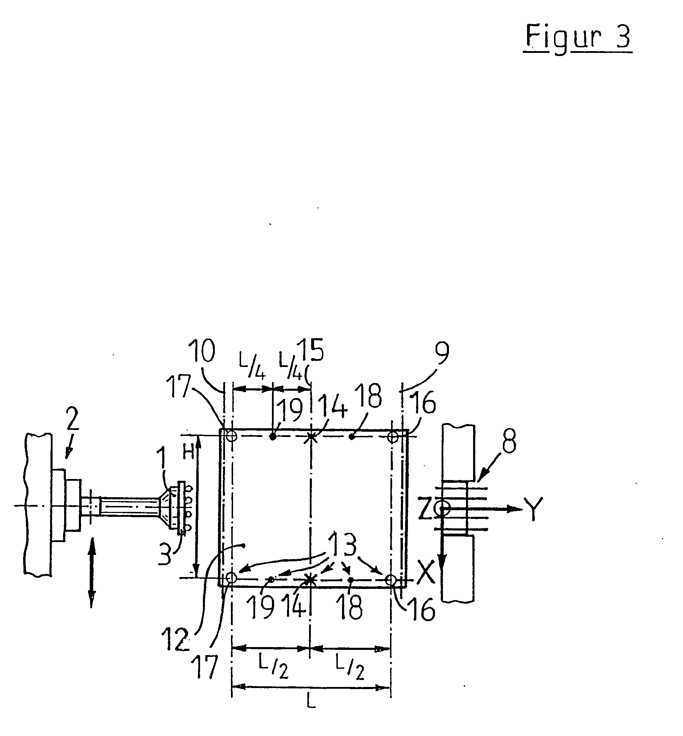

Figur 3 eine schematische Draufsicht auf eine erfindungsgemäße Vorrichtung zum zielgerichteten Bewegen von elektronischen Bauteilen, wobei auf der Vorrichtung zur Reflexion Kalibrierungsmarkierungen dargestellt sind und die um zwei Drehachsen drehbare Aufhängung der Vorrichtung zur Reflexion aus Übersichtlichkeitsgründen nicht dargestellt ist.

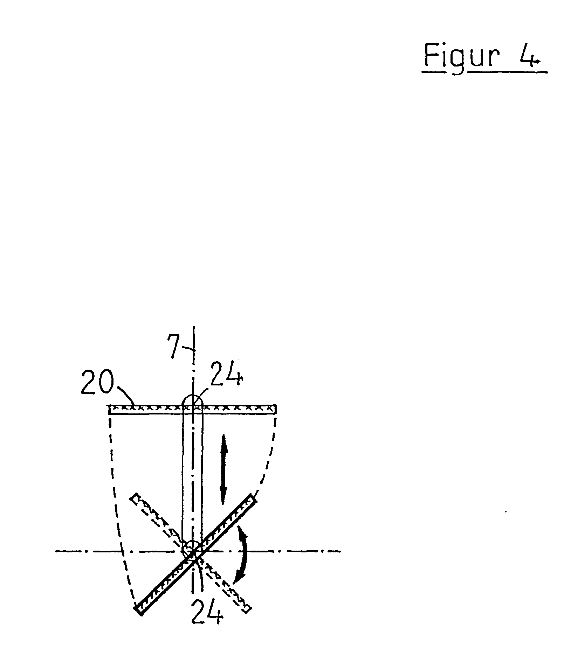

Figur 4 eine schematische Seitenansicht einer um ihre mittige Drehachse drehbaren Vorrichtung zur Reflexion, wobei die mittige Drehachse in Richtung der optischen Achse zwischen der Handhabungseinrichtung und der Kontakteinrichtung verschiebbar ist.

Wie bereits aus Figur 1 hervorgeht, umfaßt die erfindungsgemäße Vorrichtung zum zielgerichteten Bewegen von elektronischen Bauteilen zunächst mindestens eine Handhabungseinrichtung (2) zur Aufnahme, zum Schwenken, zum Verschieben und/oder zum Drehen um und/oder entlang der x-Achse und/oder y-Achse und/oder z-Achse sowie zum Ablegen von mindestens einem elektronischen Bauteil (3).

Weiterhin umfaßt die erfindungsgemäße Vorrichtung zum zielgerichteten Bewegen von elektronischen Bauteilen mindestens eine der Handhabungseinrichtung (2) gegenüberliegende elektrische Kontakteinrichtung (8) zur Herstellung mindestens einer elektrisch leitenden Verbindung zwischen mindestens einem auf seine Güte zu prüfenden elektronischen Bauteil (3) und einer der Kontakteinrichtung (8) nachgeschalteten Prüfeinrichtung.

Zwischen der Handhabungseinrichtung (3) und der Kontakteinrichtung (8) kann sich eine optische Achse (11) horizontal, vertikal oder schräg erstrecken.

Ein wesentliches Merkmal der erfindungsgemäßen Vorrichtung zum zielgerichteten Bewegen von elektronischen Bauteilen ist darin zu sehen, daß sie eine, zwei, drei oder mehrere Vorrichtungen (12) zur Reflexion von Schall- oder Lichtwellen umfaßt.

Diese mindestens eine Vorrichtung (12) zur Reflexion kann in die optische Achse (11) zwischen der Handhabungseinrichtung (2) und der Kontakteinrichtung (8) translatorisch und/oder rotatorisch vollständig oder teilweise einschiebbar sein.

Alternativ oder zusätzlich hierzu kann die mindestens eine Vorrichtung (12) zur Reflexion um eine kontakteinrichtungsseitige Drehachse (9) und/oder eine handhabungseinrichtungsseitige Drehachse (10) translatorisch und/oder rotatorisch vollständig oder teilweise in die optische Achse (11) zwischen der Handhabungseinrichtung (2) und der Kontakteinrichtung (8) einschwenkbar gelagert sein.

In der Regel bildet die mindestens eine Vorrichtung (12) zur Reflexion in einer Endstellung die Kontaktseite (4) des zu testenden elektronischen Bauteils (3) und in einer anderen Endstellung die Kontaktseite (6) der Kontakteinrichtung (8) in Richtung einer oder mehrerer außerhalb der zwischen der Handhabungseinrichtung (2) und der Kontakteinrichtung (8) verlaufenden optischen Achse (11) vorgesehener Meßvorrichtungen (5) ab.

Alternativ oder zusätzlich hierzu bildet die mindestens eine Vorrichtung (12) zur Reflexion vollständig oder teilweise auch die der Kontakteinrichtung (8) zugewandte Seite der Handhabungseinrichtung (2) in Richtung einer oder mehrerer außerhalb der zwischen der Handhabungseinrichtung (2) und der Kontakteinrichtung (8) verlaufenden optischen Achse (11) vorgesehener Meßvorrichtungen (5) ab.

Das Meßfeld der mindestens einen Meßvorrichtung (5) erfaßt die Vorrichtung (12) zur Reflexion vollständig oder vorzugsweise teilweise.

In der Regel ist die mindestens eine Meßvorrichtung (5) von der aus der optischen Achse (11) zwischen der Handhabungseinrichtung (2) und der Kontakteinrichtung (8) herausgenommenen Vorrichtung (12) zur Reflexion im Bereich von 5 mm bis 50 cm starr oder veränderlich entfernt vorgesehen.

Vorzugsweise schneidet die optische Achse (23) der mindesten einen Meßvorrichtung (5) die optische Mittenachse (7) der Vorrichtung (12) zur Reflexion gegebenenfalls etwa in Höhe der optischen Achse (11) zwischen der Handhabungseinrichtung (2) und der Kontakteinrichtung (8) starr oder veränderlich unter einem Winkel α. Dieser Winkel α liegt beispielsweise im Bereich von -30° bis +30°.

Alternativ oder zusätzlich hierzu kann die optische Achse (23) der mindestens einen Meßvorrichtung (5) starr oder veränderlich im wesentlichen parallel zu der optischen Mittenachse (7) der Vorrichtung (12) zur Reflexion verlaufen oder mit dieser im wesentlichen deckungsgleich sein.

In besonders bevorzugten Ausführungsformen ist die mindestens eine Vorrichtung (12) zur Reflexion von Licht- oder Schallwellen im wesentlichen in Form eines Spiegels (20) ausgebildet.

Wie aus den Figuren 1 bis 3 hervorgeht, kann dieser Spiegel (20) beispielsweise um eine kontakteinrichtungsseitige Drehachse (9) und um eine handhabungseinrichtungsseitige Drehachse (10) in die optische Achse (11) zwischen der Handhabungseinrichtung (2) und der Kontakteinrichtung (8) teilweise oder vollständig schwenkbar oder einschiebbar gelagert sein.

Von besonderem Vorteil ist in diesem Falle, daß mit einem einzigen Spiegel (20) bei einer Drehung um die kontakteinrichtungsseitige Drehachse (9) in Richtung der zwischen der Handhabungseinrichtung (2) und der Kontakteinrichtung (8) verlaufenden optischen Achse (11) die Kontaktseite (4) des von der Handhabungseinrichtung (2) aufgenommenen Bauelementes (3) in Richtung der mindestens einen Meßvorrichtung (5) abbildbar ist.
Bei einer Drehung des Spiegels (20) um die gegebenenfalls handhabungseinrichtungsseitige Drehachse (10) in Richtung der optischen Achse (11) kann die bauelementwärtige Kontaktseite (6) der Kontakteinrichtung (8) in Richtung der mindestens einen Meßvorrichtung (5) abgebildet werden.

Die Figuren 1 und 2 zeigen, daß in bevorzugten Ausführungsformen der Spiegel (20) derart um die kontakteinrichtungsseitige Drehachse (9) und die handhabungseinrichtungsseitige Drehachse (10) jeweils nach unten oder oben drehbar gelagert sein kann, daß eine Schwenkbarkeit des Spiegels (20) aus einer horizontalen Ausgangslage (0°) in die beiden Endpositionen von jeweils 45° gegeben ist.

In seiner im wesentlichen horizontalen Ausgangslage ist der Spiegel (20) vorzugsweise außerhalb der optischen Achse (11) zwischen der Handhabungseinrichtung (2) und der Kontakteinrichtung (8) vorgesehen und kann hierbei beispielsweise im wesentlichen parallel zu dieser optischen Achse (11) ausgerichtet sein. In der Regel ragt der Spiegel (20) zumindest in seinen jeweiligen 45°-Endpositionen in die optische Achse (11) vollständig oder teilweise hinein.

Aus Figur 4 geht hervor, daß die beispielsweise in Form eines Spiegels (20) ausgebildete Vorrichtung (12) zur Reflexion von Licht- oder Schallwellen beispielsweise lediglich um eine mittige Drehachse (24) drehbar gelagert sein kann.
Vorzugsweise ist diese mittige Drehachse (24) dann so weit in Richtung der optischen Achse (11) zwischen der Handhabungseinrichtung (2) und der Kontakteinrichtung (8) verstellbar gelagert, daß sich die Vorrichtung (12) zur Reflexion zumindest in ihren geschwenkten Endstellungen vollständig oder teilweise in der optischen Achse (11) zwischen der Handhabungseinrichtung (2) und der Kontakteinrichtung (8) befindet.

Auch in diesem Falle kann mit einem einzigen Spiegel (20) bei einer Drehung um die mittige Drehachse (24) in einer ersten, beispielsweise 45°-Schwenkendstellung die Kontaktseite (4) des von der Handhabungseinrichtung (2) aufgenommenen Bauelementes (3) und bei einer Drehung um die mittige Drehachse (24) in eine entgegengesetzte beispielsweise 45°-Schwenkendstellung die bauelementwärtige Kontaktseite (6) der Kontakteinrichtung (8) in Richtung der mindestens einen Meßvorrichtung (5) abgebildet werden.

In einer bevorzugten derartigen Ausführungsform ist der Spiegel (20) derart um seine mittige Drehachse (24) drehbar gelagert, daß eine Schwenkbarkeit des Spiegels (20) aus einer horizontalen Ausgangslage (0°) in die beiden Endpositionen von jeweils 45° gegeben ist. Hierbei kann der Spiegel (20) in seiner im wesentlichen horizontalen Ausgangslage außerhalb der optischen Achse (11) zwischen der Handhabungseinrichtung (2) und der Kontakteinrichtung (8) und gegebenenfalls im wesentlichen parallel zu dieser optischen Achse (11) vorgesehen sein. Aufgrund einer Verschiebung seiner mittleren Drehachse (24) in Richtung der optischen Achse (11) sowie aufgrund einer zumindest teilweisen Rotation um die mittlere Drehachse (24) kann die Vorrichtung (12) zur Reflexion zumindest in ihren jeweiligen 45°-Endpositionen vollständig oder teilweise in die optische Achse (11) hineinragen.

Die drehbare Anbringung der Vorrichtung (12) zur Reflexion an einer mittigen und in Richtung der optischen Achse (11) zwischen der Handhabungseinrichtung (2) und der Kontakteinrichtung (8) verfahrbaren Drehachse (24) führt insbesondere zu dem Vorteil, daß die Länge L einer derartigen Vorrichtung (12) zur Reflexion im Vergleich zur Länge L einer um eine handhabungseinrichtungsseitige Drehachse (10) und eine bauteilseitige Drehachse (9) drehbaren Vorrichtung (12) zur Reflexion deutlich kürzer gewählt werden kann, beispielsweise um etwa 30 %.

Der Abstand L zwischen den Markierungen (17) und (16) derselben Seite der Vorrichtung (12) zur Reflexion liegt hier beispielsweise im Bereich von nur 25 mm bis 170 mm, vorzugsweise im Bereich von 27 mm bis 150 mm, insbesondere im Bereich von 30 mm bis 140 mm.

Diese Verkürzung der Vorrichtung (12) zur Reflexion führt insbesondere zu dem Vorteil einer deutlichen Verbesserung der Bewegungsdynamik aufgrund erheblich geringerer zu bewegender Massen.

Die Kürze einer derartigen um ihre mittige Drehachse (24) drehbaren Vorrichtung (12) zur Reflexion erlaubt ferner einen um beispielsweise 50 mm kürzeren Abstand zwischen der Aufnahmeposition der Handhabungseinrichtung (2) und der Kontakteinrichtung (8). Das aufgenommene elektronische Bauteil (3) muß dann lediglich um eine etwa ein Drittel kürzere Strecke verfahren werden, bevor es mit der Kontakteinrichtung (8) in elektrisch leitenden Kontakt gebracht wird.
Diese markante Verkürzung der Verfahrstrecke des aufgenommenen elektronischen Bauteils (3) -beziehungsweise des Kontaktierhubes- macht sich insbesondere hinsichtlich der Genauigkeit der Anlieferungsausrichtung und Anlieferungspositionierung des elektronischen Bauteils (3) und damit hinsichtlich der Kontaktierungsqualität sehr vorteilhaft bemerkbar.

Die Kürze einer derartigen um ihre mittige Drehachse (24) drehbaren Vorrichtung (12) zur Reflexion ist schließlich auch deshalb vorteilhaft, weil der kleinere und günstiger verlaufende Schwenkbereich der Vorrichtung (12) zur Reflexion die Anbringung einer deutlich dickeren Schicht von Wärmeisolierungsmaterial insbesondere in dem Bereich um die Kontakteinrichtung (8) herum erlaubt. Dieser Umstand macht sich im Hinblick auf eine erhebliche Verbesserung der Temperaturführung bemerkbar, welche insbesondere bei Ausführungsformen mit einer Temperaturkammer von Bedeutung ist.

Aufgrund einer günstigeren Aufhängung der Vorrichtung (12) zur Reflexion in ihrem Masseschwerpunkt kann ferner der Antrieb der Vorrichtung (12) zur Reflexion kleiner dimensioniert und energiesparender ausgelegt werden.

Vorzugsweise erfaßt die mindestens eine Meßvorrichtung (5) in diesem Falle die gesamte abbildende Fläche der um ihre mittige Drehachse (24) drehbaren Vorrichtung (12) zu Reflexion.

In besonders bevorzugten Ausführungsformen kann die Vorrichtung (12) zur Reflexion eine, zwei, drei, vier, fünf, sechs, sieben, acht, neun, zehn, elf, zwölf oder mehrere über die mindestens eine Meßvorrichtung (5) vollständig oder zumindest teilweise wahrnehmbare Markierungen (13) aufweisen (siehe Figur 3).

Diese Markierungen (13) können zur Kalibrierung sowie zur Bestimmung der Lage und/oder der Ausrichtung der Handhabungseinrichtung (2), der von der Handhabungseinrichtung (2) aufgenommenen elektronischen Bauteile (3) sowie der Kontakteinrichtung (8) in Bezug auf ein vorrichtungsspezifisches Koordinatensystem dienen, wobei diese Markierungen (13) dem Koordinatensystem der erfindungsgemäßen Vorrichtung zum zielgerichteten Bewegen von elektronischen Bauteilen eindeutig zugeordnet sind.

Zumal die tatsächlichen Abstände zwischen allen Markierungen (13) bekannt sind, kann insbesondere zu Kalibrierungszwecken einer einer bestimmten Pixelanzahl entsprechenden Länge auf dem von der Meßvorrichtung (5) gelieferten Bild ein eindeutiger Wert beispielsweise in Millimetern zugeordnet werden.

Ist beispielsweise die Fehlausrichtung eines von dem Bauteilhalter (1) aufgenommenen elektronischen Bauteils (3) in Millimeter-Werten errechnet, können in Inkremente unterteilte Stellgrößen von der Datenverarbeitungseinrichtung errechnet und gegebenenfalls an die Antriebseinrichtungen der Handhabungseinrichtung (2) und/ oder des Bauteilhalters (1) und/oder der Verstelleinrichtung geleitet werden.

Selbstverständlich können die an die abzugebenden Inkremente bei Kenntnis der exakten Markierungsabstände auch ohne vorherige Umwandlung in Millimeter-Werte unmittelbar aus der Pixelanzahl ermittelt werden.

Aus Figur 3 geht hervor, daß die Markierungen (13) der Vorrichtung (12) zur Reflexion beispielsweise zumindest in den Randbereichen und/oder in den Eckbereichen der Vorrichtung (12) zur Reflexion vorgesehen sein können.

Figur 3 zeigt, daß in einer bevorzugten Ausführungsform der erfindungsgemäßen Vorrichtung (12) zur Reflexion in Form eines Spiegels (20) beispielsweise ein erstes Paar (14) von Markierungen (13) auf der parallel und mittig zu den Drehachsen (9, 10) verlaufenden Mittenachse (15) liegen kann.

Ein zweites Paar (16) von Markierungen (13) kann sich beispielsweise in dem kontakteinrichtungsseitigen Randbereich der Vorrichtung (12) zur Reflexion befinden, während ein drittes Paar (17) von Markierungen (13) gegebenenfalls im handhabungseinrichtungsseitigen Randbereich der Vorrichtung (12) zur Reflexion vorgesehen sein kann.

Der Abstand zwischen der Markierung (16) und der Markierung (17) einer Seite der Vorrichtung (12) zur Reflexion kann beispielsweise die Länge L aufweisen. Der Abstand zwischen den Markierungen (16) und (14) sowie zwischen den Markierungen (14) und (17) einer Seite der Vorrichtung (12) zur Reflexion kann dann beispielsweise jeweils L/2 betragen.

Aus Figur 3 geht ferner hervor, daß eine erfindungsgemäße Vorrichtung (12) zur Reflexion in Form eines Spiegels (20) weiterhin ein viertes Paar (18) von gegenüberliegenden Markierungen zwischen den Markierungen (16) und (14) sowie ein fünftes Paar (19) von gegenüberliegenden Markierungen zwischen den Markierungen (14) und (17) aufweisen kann.

Vorzugsweise beträgt der Abstand zwischen den Markierungen (18) und (16) sowie zwischen den Markierungen (18) und (14) einerseits und zwischen den Markierungen (19) und (14) sowie zwischen den Markierungen (19) und (17) andererseits jeweils L/4.

Der Abstand L zwischen den Markierungen (17) und (16) derselben Seite der Vorrichtung (12) zur Reflexion kann beispielsweise im Bereich von 50 mm bis 200 mm liegen.

Der Abstand H zwischen den Markierungen (13) einer Seite der Vorrichtung (12) zur Reflexion und den gegenüberliegenden Markierungen (13) der anderen, gegenüberliegenden Seite der Vorrichtung (12) ist in der Regel größer als der Abstand L/2 und liegt beispielsweise im Bereich von 51 mm bis 500 mm.

Aus den Figuren 1 und 2 geht hervor, daß die Handhabungseinrichtung (2) beispielsweise mindestens einen Bauteilhalter (1) gegebenenfalls in Form mindestens eines Greifers oder Saugers umfassen kann. Dieser Bauteilhalter (1) ist vorzugsweise um mindestens 90 oder 180° um eine beispielsweise parallel zur Kontaktierungsebene verlaufende Drehachse (21) schwenkbar gelagert, so daß die Bauteilaufnahmefläche des Bauteilhalters (1) im wesentlichen parallel zur Kontaktseite (6) der elektrischen Kontakteinrichtung (8) ausrichtbar ist.

Vorzugsweise ist die mindestens eine Handhabungseinrichtung (2) zur Aufnahme, zum Schwenken, zum Verschieben und/oder zum Drehen um und/oder entlang der x- und/oder y- und/oder z-Achse sowie zum Ablegen von mindestens einem elektronischen Bauteil (3) über eine hier nicht dargestellte Verstelleinrichtung entlang und/oder um die x- und/oder y- und/oder z-Achse verstellbar.

In bevorzugten Ausführungsformen umfaßt die mindestens eine Verstelleinrichtung zur Verstellung der Handhabungseinrichtung (2) im wesentlichen zwei zueinander parallele und voneinander zumindest etwas beabstandete Führungsschienen. Diese Verstelleinrichtung kann ferner einen rechtwinklig zu den Führungsschienen sich erstreckenden Querträger umfassen, welcher längsverschiebbar auf den Führungsschienen gelagert ist. Stirnseitig und in Richtung der elektronischen Kontakteinrichtung (8) weisend, kann auf dem Querträger eine Vielzahl von Handhabungseinrichtungen (2) entlang der x-Achse und/oder der y- Achse und/oder der z-Achse verschiebbar und/oder schwenkbar angebracht sein.

Die Verschiebungen oder Verschwenkungen der Handhabungseinrichtungen (2) um gleiche oder unterschiedliche Achsen können abhängig oder unabhängig voneinander vornehmbar sein.

In besonders bevorzugten Ausführungsformen kann die erfindungsgemäße Vorrichtung zum zielgerichteten Bewegen von elektronischen Bauteilen (3) eine Temperaturkammer umfassen.

Innerhalb dieser Temperaturkammer können zumindest ein Abschnitt eines Fördermittels (22), eine elektronische Kontakteinrichtung (8) sowie mindestens eine Handhabungseinrichtung (2) zur Aufnahme, zum Schwenken, zum Verschieben und/oder zum Drehen um und/oder entlang der x- und/oder y- und/oder z-Achse sowie zum Ablegen von mindestens einem elektronischen Bauteil (3) und eine Vorrichtung (12) zur Reflexion vorgesehen sein.
In der Regel sind die Antriebsmittel zur Bewegung des mindestens einen Fördermittels und/oder der mindestens einen Handhabungseinrichtung (2) und/oder der mindestens einen Verstelleinrichtung und die mindestens eine Meßvorrichtung (5) außerhalb der Temperaturkammer vorgesehen.

Vorzugsweise umfaßt die erfindungsgemäße Vorrichtung zum zielgerichteten Bewegen von elektronischen Bauteilen (3) mindestens ein Fördermittel (22) zur Anlieferung und/oder zum Abtransport elektronischer Bauteile in die oder aus der Temperaturkammer.
Dieses Fördermittel (22) kann beispielsweise bandförmig ausgestaltet sein. In besonders bevorzugten Ausführungsformen transportiert ein weiteres -gegebenenfalls bandförmiges- Fördermittel die nach Güteklassen sortiert auf ihm abgelegten, geprüften elektronischen Bauteile (3) aus der Temperaturkammer heraus.

In der Regel umfaßt die erfindungsgemäße Vorrichtung zum zielgerichteten Bewegen von elektronischen Bauteilen (3) beispielsweise eine zentrale Datenverarbeitungseinrichtung.
Diese zentrale Datenverarbeitungseinrichtung kann gegebenenfalls mindestens mit einer Meßvorrichtung (5) sowie mit einer der elektronischen Kontakteinrichtung (8) nachgeschalteten Prüfeinrichtung einerseits und den Antriebselementen zum Antrieb der Vorrichtung (12) zur Reflexion und/oder der mindestens einen Handhabungseinrichtung (2) und/oder der mindestens einen Verstelleinrichtung und/oder des mindestens einen Fördermittels (22) andererseits in Verbindung stehen.

Ein wesentliches Merkmal der Datenverarbeitungseinrichtung kann beispielsweise darin bestehen, daß sie gegebenenfalls derart ausgestaltet ist, daß sie den in Pixel von der Meßvorrichtung (5) mitgeteilten Pixel-Abstand zwischen den Markierungen (13) auf der Vorrichtung (12) zur Reflexion einerseits und beispielsweise dem äußeren Umfang eines von dem Bauteilhalter (1) aufgenommenen elektronischen Bauteils (3) andererseits mittelbar oder unmittelbar in gegebenenfalls mit einem Korrekturwert beaufschlagte Inkremente für die diversen Antriebsformen umrechnet.

Die mindestens eine zentrale Datenverarbeitungseinrichtung kann beispielsweise mindestens einen programmierbaren Mikroprozessor enthalten, welcher derart ausgebildet ist, daß er aus den von der Meßvorrichtung (5) eingehenden Meßsignalen die Lage und/oder den Drehwinkel sowie den geometrischen Flächenschwerpunkt des zu bewegenden elektronischen Bauteils (3) ermittelt, die Abweichungen des Aufsetzortes der Aufnahmefläche des Bauteilhalters (1) auf dem elektronischen Bauelement (3) von dessen Fläschenschwerpunkt bestimmt und ein diese Abweichungen kompensierendes Korrektursignal ermittelt und an die Antriebsmittel der Handhabungseinrichtung (2) und/oder der Verstelleinrichtung Stellgrößen übermittelt, welche zur Feinabstimmung mit den Korrektursignalen beaufschlagt sind. Die Stellgrößen sind vorzugsweise durch den Ort und die Lage des aufzunehmenden oder bereits aufgenommenen elektronischen Bauteils (3), den Ort und die Lage der elektrischen Kontakteinrichtung (8) sowie die Position und Lage des der jeweiligen Güteklasse entsprechenden Absetzortes bestimmt.

Außerdem kann der Mikroprozessor derart ausgestaltet sein, daß er beispielsweise in Abhängigkeit von der Position des Bauteilhalters (1) und/oder der Handhabungseinrichtung (2) und/oder der Handhabungseinrichtungs-Verstellvorrichtung Stellgrößen an den Antrieb der Vorrichtung (12) zur Reflexion abgibt. Die Ansteuerung des Antriebs der Vorrichtung (12) zur Reflexion erfolgt insbesondere derart, daß eine mechanische Beschädigung der Vorrichtung (12) zur Reflexion durch den in Richtung der Kontakteinrichtung (8) verfahrenden Bauteilhalter (1) mit Sicherheit ausgeschlossen ist.

In der Regel gibt der mindestens eine Mikroprozessor diese Stellgrößen derart an die Antriebsmittel der Handhabungseinrichtung (2) und der Verstelleinrichtung ab, daß das über den Bauteilhalter (1) aufgenommene elektronische Bauteil (3) zunächst mit einem für die Messung ausreichenden Anpreßdruck paßgenau mit der elektrischen Kontakteinrichtung (8) in Eingriff kommt und der mit dem elektronischen Bauteil (3) beladene Bauteilhalter (1), im Anschluß an die Messung, aus der horizontalen oder vertikal nach oben weisenden Meßstellung nach unten schwenkt und das elektronische Bauteil (3) in Abhängigkeit von dem Prüfergebnis sortiert nach Güteklassen auf dem mindestens einen abtransportierenden Fördermittel (22) ablegt.

Bei der mindestens einen Meßvorrichtung (5) kann es sich beispielsweise um eine mechanische oder mindestens eine berührungslose optische, elektrische, kapazitive oder induktive Meßvorrichtung handeln.

Sofern die Meßvorrichtung (5) in Form einer optischen Meßvorrichtung ausgebildet ist, umfaßt diese vorzugsweise ein besonders kostengünstiges, leichtes und einfach herzustellenden entozentrisches Objektiv.
Selbstverständlich ist es jedoch möglich, anstelle eines entozentrischen Objektives ein sehr viel teureres telezentrisches Objektiv zu verwenden.

Das Blickfeld dieser Meßvorrichtung (5) ist im wesentlichen vollständig oder teilweise auf die Vorrichtung (12) zur Reflexion gerichtet. In der Regel steht die mindestens eine Meßvorrichtung (5) mit der Datenverarbeitungseinrichtung und über diese mit den Antriebselementen des Fördermittels (22) und/oder der Handhabungseinrichtung (2) und/oder der Verstelleinrichtung in Verbindung.

Zusammenfassend ist nun festzustellen, daß die vorliegende Erfindung eine Vorrichtung zum zielgerichteten Bewegen von elektronischen Bauteilen bereitstellt, welche mit einem einzigen, besonders einfach und kostengünstig herzustellenden und keine exakte Justage erfordernden Betrachtungssystem sowohl die Betrachtung der Kontaktseite (4) der zu prüfenden elektronischen Bauteile als auch die Betrachtung der Kontaktseite (6) der Kontakteinrichtung erlaubt. Dies ist beispielsweise aufgrund der beidseitig schwenkbaren Aufhängung der Vorrichtung (12) zur Reflexion um eine handhabungseinrichtungsseitige Drehachse (10) sowie um eine kontakteinrichtungsseitige Drehachse (9) möglich.

Bei der aus dem Stand der Technik bekannten Vorrichtung zum zielgerichteten Bewegen von elektronischen Bauteilen ist eine hochpräzise Ausrichtung der optischen Achse der Meßvorrichtung mit der optischen Mittenachse der Vorrichtung zur Reflexion erforderlich. Außerdem ist dort die exakte Einhaltung eines vorgegebenen Abstandes der Meßvorrichtung von der Reflexionsvorrichtung notwendig.

Im Falle der erfindungsgemäßen Vorrichtung zum zielgerichteten Bewegen von elektronischen Bauteilen ist im scharfen Gegensatz hierzu eine exakte Ausrichtung der optischen Achse (23) der Meßvorrichtung (5) mit der optischen Mittenachse (7) der Vorrichtung (12) zur Reflexion gerade nicht notwendig. Auch der Abstand der Meßvorrichtung (5) von der Vorrichtung (12) zur Reflexion ist im Falle der erfindungsgemäßen Vorrichtung zur zielgerichteten Bewegung von elektronischen Bauteilen in einem sehr weiten Bereich variabel.
Denn dieser Abstand wird im wesentlichen nur dadurch bestimmt, daß die entsprechenden Markierungen bei geschwenktem Spiegelstand scharf erkennbar sein sollten. Der einzuhaltende Abstand ist somit größtenteils nur von dem jeweils verwendeten Objektiv abhängig. Im Falle der erfindungsgemäßen Vorrichtung zum zielgerichteten Bewegen elektronischer Bauteile ist also die Bereitstellung eines schweren und teuren Stativs zur exakt ortstreuen Fixierung der Meßvorrichtung (5) nicht erforderlich. Vielmehr reicht hier das einfache Scharfstellen des Objektivs der Meßvorrichtung aus. Gegebenenfalls kann das Objektiv nach Scharfstellung durch einen Tropfen Klebstoff hinsichtlich der vorgenommenen Schärfeeinstellung fixiert werden.

Um die genaue Lage und Ausrichtung der Handhabungseinrichtung (2), des Bauteilhalters (1), des aufgenommenen elektronischen Bauteils (3) oder der Kontakteinrichtung (8) in Bezug auf das vorrichtungsspezifische Koordinatensystem eindeutig bestimmen zu können, ist im Falle der erfindungsgemäßen Vorrichtung lediglich erforderlich, daß die Meßvorrichtung (5) zumindest einen Teil der auf der Vorrichtung (12) zur Reflexion angebrachten Markierungen (13) und die virtuellen Abstände des zu begutachtenden Teils (elektronisches Bauteil (3), Bauteilhalter (1) oder Kontakteinrichtung (8)) von diesen Markierungen erfassen kann. Die Blickrichtung der Meßvorrichtung (5) spielt hierbei eine völlig untergeordnete Rolle und ist deshalb in dem weiten α-Winkelbereich von insgesamt etwa 60° variabel.
Vorzugsweise ist das Blickfeld der Meßvorrichtung zumindest jeweils auf die sechs Markierungen am jeweils freien Ende des Spiegels (20) und das dazwischenliegende Bild des zu begutachtenden Teils gerichtet.

Die ausgeprägte Unabhängigkeit von der Einhaltung einer exakten Montageposition der Meßvorrichtung (5) macht sich im Falle der erfindungsgemäßen Vorrichtung insbesondere dann vorteilhaft bemerkbar, wenn die Vorrichtung Stößen von außen oder betriebsbedingten Vibrationen und Schwingungen ausgesetzt ist.

Hierzu kommt es beispielsweise, wenn sich das Bedienungspersonal an das Gehäuse lehnt oder wenn dynamische Bewegungen stattfinden, beispielsweise in Form von durch Beschleunigungskräfte hervorgerufene Bewegungen des Positionierungssystems. Aufgrund solcher Störungen erfährt dort die Spiegelhalterung eine störende Relativbewegung gegenüber der Kamerahalterung.

Auch eine durch unterschiedliche Wäremausdehungskoeffizienten bedingte Temperaturdrift zwischen der auf Raumtemperatur gehaltenen Kamerahalterung und der bei hohen Temperaturen innerhalb der Temperaturkammer vorgesehenen Spiegelaufhängung kann dort zu ungewollten und extrem störenden Änderung der Kameraposition führen.

Während die Vorrichtung des Standes der Technik bei der Einwirkung von äußerlichen Stößen, betriebsbedingten Vibrationen und Schwingungen oder bei dem Auftreten einer Temperaturdrift Fehlmessungen mit unnötig hohen Ausschußquoten erbringt und erhebliche Einbußen hinsichtlich der Beobachtungsgenauigkeit bis hin zum Verlust der Funktionsfähigkeit erfährt, haben diese Einflüsse aufgrund des sehr großen Bereichs erlaubter Positionen der Meßvorrichtung (5) keine störenden Auswirkungen auf die Meßgenauigkeit oder gar die Funktionstüchtigkeit der erfindungsgemäßen Vorrichtung.

Daß im Falle der erfindungsgemäßen Vorrichtung auf die im Stand der Technik gefürchtete hochpräzise Justage der Meßvorrichtung (5) verzichtet werden kann, verkörpert darüber hinaus einen erheblichen Vorteil hinsichtlich der Herstellungskosten, der Montage und des Wartungsaufwandes. So reicht bei der erfindungsgemäßen Vorrichtung sogar eine besonders kostengünstige instabile Aufhängung für die die Vorrichtung (12) zur Reflexion teilweise oder vollständig betrachtende Meßvorrichtung (5) völlig aus.

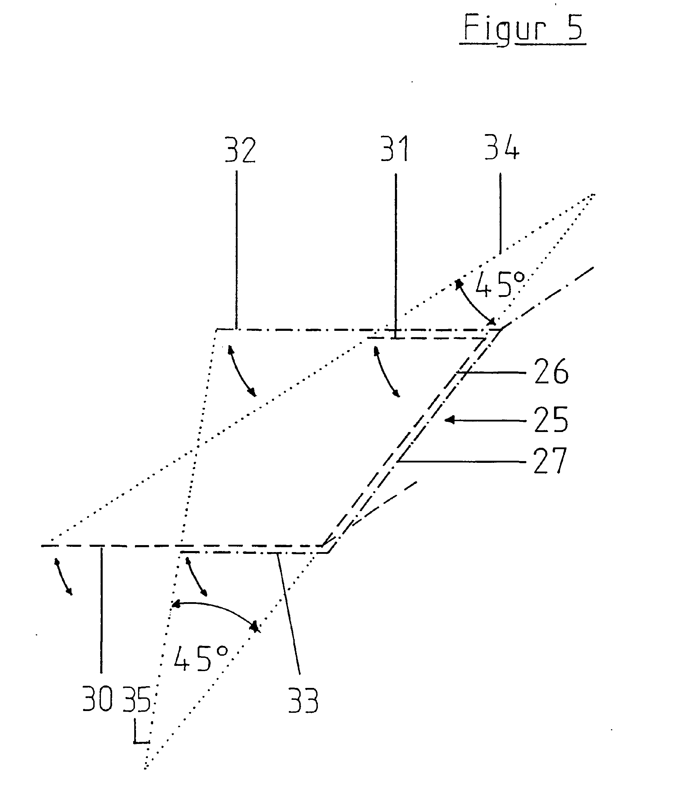

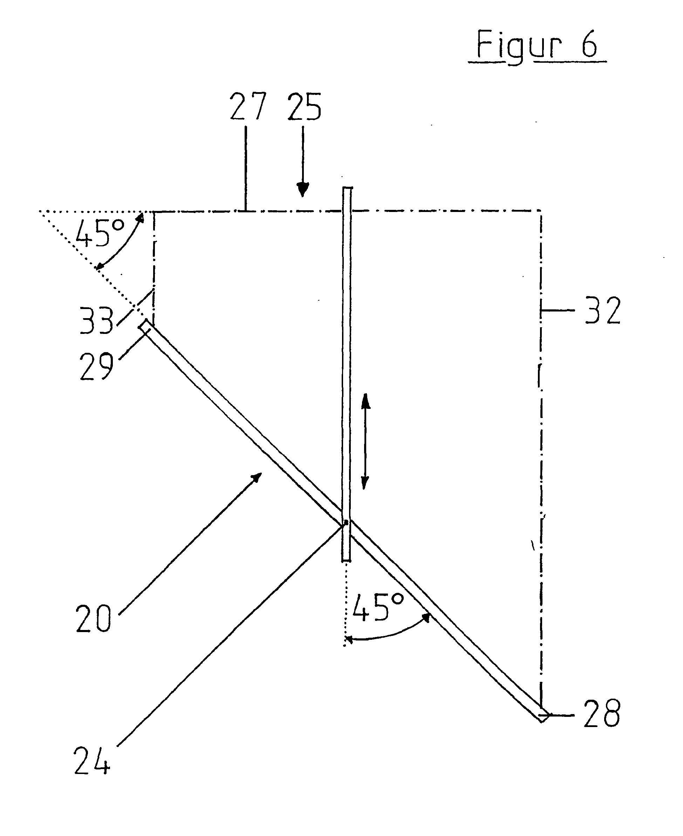

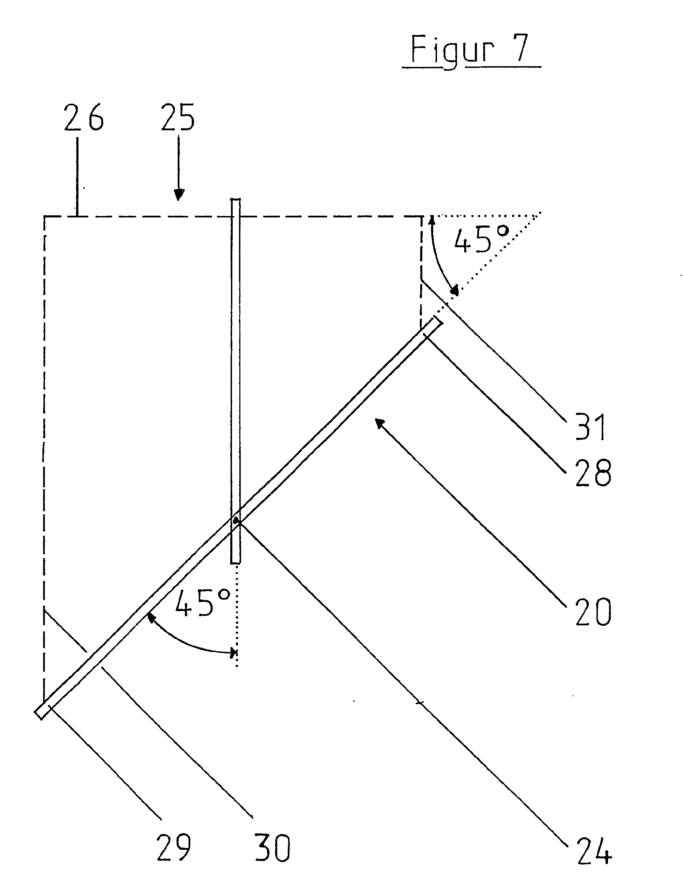

Wie in den Figuren 4 bis 7 dargestellt, kann in einer besonders bevorzugten Ausführungsform der erfindungsgemäßen Vorrichtung der Spiegel (20) derart um seine mittige Drehachse (24) drehbar gelagert sein, daß eine Schwenkbarkeit des Spiegels (20) aus einer horizontalen Ausgangslage (0°) in zwei entgegengesetzt geneigte Endpositionen von jeweils 45° gegeben ist.

Die Antriebskinematik eines Spiegels (20) kann in diesem Falle einseitig oder beidseitig von dem Spiegel (20) jeweils eine koaxiale Wellenanordnung (25) mit zwei gegeneinander frei verdrehbaren Wellen (26, 27) umfassen.

Vorzugsweise trägt dann jede Welle (26, 27) U-artig ein Paar von auf gegenüberliegende Randbereiche (28, 29) des Spiegels (20) mittelbar oder unmittelbar einwirkenden und unterschiedlich langen Schwenkhebeln (30, 31; 32, 33).

In der Regel sind die unterschiedlichen Längen der beiden zu derselben Welle (26, 27) gehörenden Schwenkhebel (30, 31; 32, 33) derart gewählt, daß eine durch die freien Enden der jeweils zusammenwirkenden Schwenkhebel (30, 31; 32, 33) gedachte Linie (34; 35) eine gedachte Verlängerung der koaxialen Wellenanordnung (25) in einem Winkel von jeweils 45° schneidet.

In diesem Falle kann es durch das Schwenken des einen Paares von Schwenkhebeln (30, 31) in Richtung der optischen Achse (11) zwischen der Handhabungsvorrichtung (2) und der elektrischen Kontakteinrichtung (8) zu einem Absenken des Spiegels (20) in den Bereich der optischen Achse (11) sowie zu einer Neigung des Spiegels (20) in eine erste 45°-Endposition kommen.

Durch das Schwenken des anderen Paares von Schwenkhebeln (32, 33) in Richtung der optischen Achse (11) zwischen der Handhabungsvorrichtung (2) und der elektrischen Kontakteinrichtung (8) kann es dann zu einem Absenken des Spiegels (20) in den Bereich der optischen Achse (11) sowie zu einer Neigung des Spiegels (20) in eine entgegengesetzte zweite 45°-Endposition kommen.

Figur 5 zeigt eine schematische perspektivische Ansicht einer derartigen Antriebskinematik von schräg oben, deren Schwenkhebel sich noch in der hochgeklappten Ausgangsstellung befinden.

Figur 6 zeigt eine schematische Seitenansicht einer derartigen Antriebskinematik, deren eines Schwenkhebelpaar (32, 33) nach unten geschwenkt ist, um den Spiegel in eine erste 45°-Endposition zu bringen.

Figur 7 zeigt eine schematische Seitenansicht einer derartigen Antriebskinematik, deren anderes Schwenkhebelpaar (30, 31) nach unten geschwenkt ist, um den Spiegel in eine entgegengesetzte 45°-Endposition zu bringen.

Eine derartige Spiegel-Antriebskinematik ist insbesondere unter den Aspekten einer äußerst geringen Raumforderung, einer besonders schnellen Erreichung der Neige-Endpositionen und der Ausgangslage, einer stets sicher gewährleisteten Ausrichtung des Spiegels (20) in 45°-Neigung sowie unter dem Aspekt einer über die Längen der Schwenkhebel (30, 31; 32, 33) exakt einstellbaren Absenkbarkeit des Spiegels (20) in die optische Achse (11) vorteilhaft.

## Patentansprüche

1. Vorrichtung zum zielgerichteten Bewegen von elektronischen Bauteilen (3), bestehend aus einer Handhabungseinrichtung (2) zur Aufnahme, zum Schwenken, zum Verschieben und/oder zum Drehen um die und/oder entlang der x- und/oder y- und/oder z-Achse sowie zum Ablegen von mindestens einem elektronischen Bauteil (3),
- mindestens einer Ablage, auf welcher das Bauteil zu positionieren ist,
- einer optischen Achse (11), welche sich zwischen der Handhabungseinrichtung (2) und der Ablage (8) horizontal, vertikal oder schräg erstreckt,
- mindestens einem Spiegel (20), welcher in die optische Achse (11) zwischen der Handhabungseinrichtung (2) und der Ablage (8) vollständig oder teilweise einschiebbar ist, wobei dieser Spiegel das Bauteil (3) einerseits und die Ablage (6) andererseits abbildet und das Messfeld der Messvorrichtung (5) den Spiegel (20) erfasst,
**dadurch gekennzeichnet, dass** die Ablage eine elektrische Kontakteinrichtung (8) zur Herstellung einer elektrisch leitenden Verbindung zwischen einem zu prüfenden elektronischen Bauteil (3) und einer der Kontakteinrichtung (8) nachgeschalteten Prüfeinrichtung ist, dass der Spiegel (20) rotatorisch um eine kontakteinrichtungsseitige Drehachse (9) und eine handhabungseinrichtungsseitige Drehachse (10) derart einschwenkbar ist, dass bei einer Drehung um die kontakteinrichtungsseitige Drehachse (9) in Richtung der zwischen der Handhabungseinrichtung (2) und der Kontakteinrichtung (8) verlaufenden optischen Achse (11) die Kontaktseite (4) des von der Handhabungseinrichtung (2) aufgenommenen Bauelementes (3) und bei einer Drehung um die handhabungseinrichtungseinrichtungsseitige Drehachse (10) in Richtung der optischen Achse (11) die bauelementwärtige Kontaktseite (6) der Kontakteinrichtung (8) in Richtung der Messvorrichtung (5) abgebildet wird, wobei die optische Achse (23) der Messvorrichtung (5) die auf der optischen Achse (11) zwischen der Handhabungseinrichtung (2) und der Kontakteinrichtung (8) in deren Mittelpunkt senkrecht stehende Mittelachse (7) etwa in Höhe der optischen Achse (11) zwischen der Handhabungseinrichtung (2) und der Kontakteinrichtung (8) starr oder veränderlich unter einem Winkel α schneidet, welcher im Bereich von -30° bis +30° liegt und/oder wobei die optische Achse (23) der Messvorrichtung (5) starr oder veränderlich parallel zur Mittelachse (7) verläuft und/oder mit dieser deckungsgleich ist.

2. Vorrichtung zum zielgerichteten Bewegen von elektronischen Bauteilen (3), bestehend aus einer Handhabungseinrichtung (2) zur Aufnahme, zum Schwenken, zum Verschieben und/oder zum Drehen um die und/oder entlang der x- und/oder y- und/oder z-Achse sowie zum Ablegen von mindestens einem elektronischen Bauteil (3),
- mindestens einer Ablage (8), auf welcher das Bauteil (3) zu positionieren ist,
- einer optischen Achse (11), welche sich zwischen der Handhabungseinrichtung (2) und der Ablage (8) horizontal, vertikal oder schräg erstreckt,
- mindestens einem Spiegel (20), welcher in die optische Achse (11) zwischen der Handhabungseinrichtung (2) und der Ablage (8) vollständig oder teilweise einschiebbar ist, wobei dieser Spiegel (20) das Bauteil (3) einerseits und die Ablage (6) andererseits abbildet und das Messfeld der Messvorrichtung (5) den Spiegel (20) erfasst,
**dadurch gekennzeichnet, dass** die Ablage eine elektrische Kontakteinrichtung (8) zur Herstellung einer elektrisch leitenden Verbindung zwischen einem zu prüfenden elektronischen Bauteil (3) und einer der Kontakteinrichtung (8) nachgeschalteten Prüfeinrichtung ist, dass der Spiegel um eine mittige Drehachse (24) translatorisch und rotatorisch einschwenkbar ist, wobei die mittige Drehachse (24) so weit in Richtung der optischen Achse (11) zwischen der Handhabungseinrichtung (2) und der Kontakteinrichtung (8) verstellbar ist, dass sich der Spiegel (20) in seinen geschwenkten. Endstellungen vollständig oder teilweise in der optischen Achse (11) zwischen der Handhabungseinrichtung (2) und der Kontakteinrichtung (8) befindet, und mit dem Spiegel (20) bei einer Drehung um die mittige Drehachse (24) in einer ersten Schwenkendstellung die Kontaktseite (4) des von der Handhabungseinrichtung (2) aufgenommenen Bauelementes (3) und bei einer Drehung um die mittige Drehachse (24) in eine entgegengesetzte Schwenkendstellung die bauelementwärtige Kontaktseite (6) der Kontakteinrichtung (8) in Richtung der Messvorrichtung (5) abbildbar ist, wobei die optische Achse (23) der Messvorrichtung (5) die auf der optischen Achse (11) zwischen der Handhabungseinrichtung (2) und der Kontakteinrichtung (8) in deren Mittelpunkt senkrecht stehende Mittelachse (7) etwa in Höhe der optischen Achse (11) zwischen der Handhabungseinrichtung (2) und der Kontakteinrichtung (8) starr oder veränderlich unter einem Winkel α schneidet, welcher im Bereich von -30° bis +30° liegt und/oder wobei die optische Achse (23) der Messvorrichtung (5) starr oder veränderlich parallel zur Mittelachse (7) verläuft und/oder mit dieser deckungsgleich ist.

3. Vorrichtung nach Anspruch 1,
**dadurch gekennzeichnet, dass** der Spiegel (20) derart um die kontakteinrichtungsseitige Drehachse (9) und die handhabungseinrichtungsseitige Drehachse (10) jeweils nach unten oder oben drehbar gelagert ist, dass eine Schwenkbarkeit des Spiegels (20) aus einer horizontalen Ausgangslage (0°) in die beiden Endpositionen von jeweils 45° gegeben ist, wobei der Spiegel (20) in seiner im wesentlichen horizontalen Ausgangslage außerhalb der optischen Achse (11) zwischen der Handhabungseinrichtung (2) und der Kontakteinrichtung (8) und gegebenenfalls im wesentlichen parallel zu dieser optischen Achse (11) vorgesehen ist und zumindest in seinen jeweiligen 45°-Endpositionen vollständig oder teilweise in die optische Achse (11) hineinragt.

4. Vorrichtung nach Anspruch 3,
**dadurch gekennzeichnet, dass** der Spiegel (20) aus einer horizontalen Ausgangslage (0°) in die beiden Endpositionen von jeweils 45° schwenkbar ist und in seiner im wesentlichen horizontalen Ausgangslage außerhalb der optischen Achse (11) zwischen der Handhabungseinrichtung (2) und der Kontakteinrichtung (8) und gegebenenfalls im wesentlichen parallel zu dieser optischen Achse (11) vorgesehen ist und aufgrund einer Verschiebung seiner mittleren Drehachse (24) in Richtung der optischen Achse (11) sowie aufgrund einer teilweisen Rotation um die mittlere Drehachse (24) zumindest in seinen jeweiligen 45°-Endpositionen vollständig oder teilweise in die optische Achse (11) hineinragt.

5. Vorrichtung nach einem oder mehreren der vorhergehenden Ansprüche,
**dadurch gekennzeichnet, dass** der Spiegel (20) eine oder mehrere mittels der Messvorrichtung (5) vollständig oder teilweise wahrnehmbare Markierungen (13) aufweist, die der Kalibrierung sowie der Bestimmung der Lage und/oder der Ausrichtung der Handhabungseinrichtung (2), der von der Handhabungseinrichtung (2) aufgenommenen elektronischen Bauteile (3) sowie der Kontakteinrichtung (8) in Bezug auf ein vorrichtungsspezifisches Koordinatensystem dienen, wobei diese Markierungen (13) dem Koordinatensystem der Vorrichtung eindeutig zugeordnet sind.

6. Vorrichtung nach Anspruch 5,
**dadurch gekennzeichnet, dass** die Markierungen (13) in den Randbereichen und/oder in den Eckbereichen des Spiegels (20) vorgesehen sind.

7. Vorrichtung nach Anspruch 5 oder 6,
**dadurch gekennzeichnet, dass** ein erstes Paar (14) von Markierungen (13) auf der parallel und mittig zu den Drehachsen (9, 10) verlaufenden Mittenachse (15, 24) liegt, dass ein zweites Paar (16) von Markierungen (13) im kontakteinrichtungsseitigen Randbereich des Spiegels (20) liegt und dass ein drittes Paar (17) von Markierungen (13) im handhabungseinrichtungsseitigen Randbereich des Spiegels liegt, wobei der Abstand zwischen der Markierung (16) und der Markierung (17) einer Seite des Spiegels die Länge L aufweist und der Abstand zwischen den Markierungen (16) und (14) sowie zwischen den Markierungen (14) und (17) einer Seite des Spiegels (20) jeweils L/2 beträgt und dass ein viertes Paar (18) von gegenüberliegenden Markierungen zwischen den Markierungen (16) und (14) sowie ein fünftes Paar (19) von gegenüberliegenden Markierungen zwischen den Markierungen (14) und (17) liegt, wobei der Abstand zwischen den Markierungen (18) und (16) sowie zwischen den Markierungen (18) und (14) einerseits und zwischen den Markierungen (19) und (14) sowie zwischen den Markierungen (19) und (17) andererseits jeweils L/4 beträgt.

8. Vorrichtung nach Anspruch 7,
**dadurch gekennzeichnet, dass** der Abstand L zwischen den Markierungen (17) und (16) derselben Seite des Spiegels (20) im Bereich von 50 mm bis 200 mm liegt.

9. Vorrichtung nach einem der Ansprüche 5 bis 8,
**dadurch gekennzeichnet, dass** der Abstand L zwischen den Markierungen (17) und (16) derselben Seite des Spiegels (20) im Bereich von 30 mm bis 150 mm liegt.

10. Vorrichtung nach einem oder mehreren der Ansprüche 5 bis 9,
**dadurch gekennzeichnet, dass** der Abstand H zwischen den Markierungen (13) einer Seite des Spiegels (20) und den gegenüberliegenden Markierungen (13) der anderen, gegenüberliegenden Seite des Spiegels (20) größer als der Abstand L/2 ist und im Bereich von 51 mm bis 500 mm liegt.

11. Vorrichtung nach einem oder mehreren der vorhergehenden Ansprüche,
**dadurch gekennzeichnet, dass** die Handhabungseinrichtung (2) einen Bauteilhalter (1) in Form eines Greifers oder Saugers aufweist, welcher um 90° oder 180° um eine parallel zur Kontaktierungsebene verlaufende Drehachse (21) derart schwenkbar ist, dass die Bauteil-Aufnahmefläche des Bauteilhalters (1) im wesentlichen parallel zur Kontaktseite (6) der elektrischen Kontakteinrichtung (8) ausrichtbar ist.

12. Vorrichtung nach einem oder mehreren der vorhergehenden Ansprüche,
**dadurch gekennzeichnet, dass** die Handhabungseinrichtung (2) zur Aufnahme, zum Schwenken, zum Verschieben und/oder zum Drehen um und/oder entlang der x- und/oder y- und/oder z-Achse sowie zum Ablegen des elektronischen Bauteils (3) über eine Verstelleinrichtung entlang und/oder um die x- und/oder y- und/oder z-Achse verstellbar ist.

13. Vorrichtung nach einem oder mehreren der vorhergehenden Ansprüche,
**dadurch gekennzeichnet, dass** die Verstelleinrichtung zur Verstellung der Handhabungseinrichtung (2) aus zwei zueinander parallel und voneinander beabstandeten Führungsschienen und einem rechtwinklig zur Längsachse der Führungsschienen sich erstreckenden Querträger besteht, welcher längsverschiebbar auf den Führungsschienen gelagert ist, wobei stirnseitig in Richtung der elektrischen Kontakteinrichtung (8) auf dem Querträger eine Vielzahl von Handhabungseinrichtungen (2) entlang der x-Achse und/oder der y-Achse und/oder der z-Achse verschiebbar und/oder verschwenkbar angebracht ist und wobei diese Verschiebungen oder Verschwenkungen der Handhabungseinrichtungen (2) um gleiche oder unterschiedliche Achsen abhängig oder unabhängig voneinander vornehmbar sind.

14. Vorrichtung nach einem oder mehreren der vorhergehenden Ansprüche,
**dadurch gekennzeichnet, dass** sie eine Temperaturkammer umfasst, innerhalb welcher zumindest ein Abschnitt eines Fördermittels (22), eine elektrische Kontakteinrichtung (8), ein Spiegel (20) sowie mindestens eine Handhabungseinrichtung (2) zur Aufnahme, zum Schwenken, zum Verschieben und/oder zum Drehen um und/oder entlang der x- und/oder y- und/oder z-Achse sowie zum Ablegen von mindestens einem elektronischen Bauteil (3) vorgesehen sind, wobei die Messvorrichtung (5) und die Antriebsmittel zur Bewegung des Fördermittels und/oder der Handhabungseinrichtung (2) und/oder der Verstelleinrichtung außerhalb der Temperaturkammer vorgesehen sind.

15. Vorrichtung nach einem oder mehreren der vorhergehenden Ansprüche,
**dadurch gekennzeichnet, dass** sie ein Fördermittel (22) zur Anlieferung elektronischer Bauteile (3) in die oder aus der Temperaturkammer umfasst.

16. Vorrichtung nach einem oder mehreren der vorhergehenden Ansprüche,
**dadurch gekennzeichnet, dass** sie eine zentrale Datenverarbeitungseinrichtung umfasst, welche mit einer Messvorrichtung (5) sowie mit einer der elektrischen Kontakteinrichtung (8) nachgeschalteten Prüfeinrichtung einerseits und den Antriebselementen zum Antrieb des Spiegels (20) und/oder der mindestens einen Handhabungseinrichtung (2) und/oder der Verstelleinrichtung und/oder des Fördermittels (22) andererseits in Verbindung steht.

17. Vorrichtung nach Anspruch 16,
**dadurch gekennzeichnet, dass** die zentrale Datenverarbeitungseinrichtung einen programmierbaren Mikroprozessor enthält, welcher derart ausgebildet ist, dass er den Antrieb des Spiegels (20) nur dann in eine Einschwenkposition steuert, wenn die zumindest teilweise zurückgefahrene Handhabungseinrichtung (2) den für das Einschwenken erforderlichen Raum lässt, und welcher ferner derart ausgestaltetet ist, dass er aus den von der Messvorrichtung (5) eingehenden Messsignalen die Lage und/oder den Drehwinkel sowie den geometrischen Flächenschwerpunkt des zu bewegenden elektronischen Bauteils (3) ermittelt, die Abweichungen des Aufsetzortes der Aufnahmefläche des Bauteilshalters (1) auf dem elektronischen Bauelement (3) von dessen Flächenschwerpunkt bestimmt und ein diese Abweichungen kompensierendes Korrektursignal ermittelt und an die Antriebsmittel der Handhabungseinrichtung (2) und/oder der Verstelleinrichtung Stellgrößen übermittelt, welche zur Feinabstimmung mit den Korrektursignalen beaufschlagt sind, wobei diese Stellgrößen grundsätzlich durch den Ort und die Lage des aufzunehmenden oder aufgenommenen elektronischen Bauteils (3), den Ort und die Lage der elektrischen Kontakteinrichtung (8) sowie die Position und Lage des der jeweiligen Güteklasse entsprechenden Absetzortes bestimmt sind und wobei der Mikroprozessor diese Stellgrößen derart an die Antriebsmittel der Handhabungseinrichtung (2) und der Verstelleinrichtung ausgibt, dass das über den Bauteilhalter (1) aufgenommene elektronische Bauteil (3) zunächst mit einem für die Messung ausreichenden Anpressdruck passgenau mit der elektrischen Kontakteinrichtung (8) in Eingriff kommt und der mit dem elektronischen Bauteil (3) beladene Bauteilhalter (1) im Anschluss an die Messung aus der horizontalen oder vertikal nach oben weisenden Messstellung nach unten schwenkt und das elektronische Bauteil (3) in Abhängigkeit von dem Prüfergebnis sortiert nach Güteklassen auf dem abtransportierenden Fördermittel (22) ablegt.

18. Vorrichtung nach Anspruch 16 oder 17,
**gekennzeichnet durch** eine mechanische oder eine berührungslose optische, elektrische, kapazitive oder induktive Messvorrichtung, deren Blickfeld im wesentlichen vollständig oder teilweise auf den Spiegel (20) gerichtet ist, wobei die Messvorrichtung (5) mit der Datenverarbeitungseinrichtung und über diese mit den Antriebselementen des Spiegels (20) und/oder des Fördermittels (22) und/oder der Handhabungseinrichtung (2) und/oder der Verstelleinrichtung in Verbindung steht.

19. Vorrichtung nach Anspruch 18,
**gekennzeichnet durch** eine optische Messvorrichtung mit einem entozentrischen Objektiv oder mit einem telezentrischen Objektiv.

20. Vorrichtung nach Anspruch 4,
**dadurch gekennzeichnet, dass** einseitig oder beidseitig von dem Spiegel (20) jeweils eine koaxiale Wellenanordnung (25) mit zwei gegeneinander frei verdrehbaren Wellen (26, 27) angebracht ist, dass jede Welle (26, 27) U-artig ein Paar von auf gegenüberliegende Randbereiche (28, 29) des Spiegels (20) mittelbar oder unmittelbar einwirkenden und unterschiedlich langen Schwenkhebeln (30, 31; 32, 33) trägt, wobei die unterschiedlichen Längen der beiden zu derselben Welle (26, 27) gehörenden Schwenkhebel (30, 31; 32, 33) derart gewählt sind, dass eine durch die freien Enden der jeweils zusammenwirkenden Schwenkhebel (30, 31; 32, 33) gedachte Linie (34, 35) eine gedachte Verlängerung der koaxialen Wellenanordnung (25) in einem Winkel von jeweils 45° schneidet und wobei es durch das Schwenken des einen Paares von Schwenkhebeln (30, 31) in Richtung der optischen Achse (11) zwischen der Handhabungsvorrichtung (2) und der elektrischen Kontakteinrichtung (8) zu einem Absenken des Spiegels (20) in den Bereich der optischen Achse (11) sowie zu einer Neigung des Spiegels (20) in eine erste 45°-Endposition kommt, während es durch das Schwenken des anderen Paares von Schwenkhebeln (32, 33) in Richtung der optischen Achse (11) zwischen der Handhabungsvorrichtung (2) und der elektrischen Kontakteinrichtung (8) zu einem Absenken des Spiegels (20) in den Bereich der optischen Achse (11) sowie zu einer Neigung des Spiegels (20) in eine entgegengesetzte zweite 45°-Endposition kommt.

## Claims

1. A device for the targeted movement of electronic components (3), consisting of a manipulation device (2) for grasping, pivoting, displacing and/or rotating at least one electronic component (3) around and/or along the x axis and/or y axis and/or z axis and for depositing said at least one electronic component (3),
- at least one area of deposit on which the component is to be positioned,
- an optical axis (11), which extends horizontally, vertically or diagonally between the manipulation device (2) and the area of deposit (8),
- at least one mirror (20), which can be completely or partially inserted into the optical axis (11) between the manipulation device (2) and the area of deposit (8), this mirror imaging the component (3) on the one hand and the area of deposit (6) on the other hand and the measurement field of the measuring instrument (5) measuring the mirror (20),
**characterised in that** the area of deposit is an electric contact device (8) for producing an electrically conductive connection between a component (3) to be tested and a testing device downstream from the contact device (8),
**in that** the mirror (20) can be rotated around an axis of rotation (9) close to the contact device and an axis of rotation (10) close to the manipulation device in such a manner that upon a rotation around the axis of rotation (9) close to the contact device towards the optical axis (11) extending between the manipulation device (2) and the contact device (8) the contact side (4) of the component (3) grasped by the manipulation device (2) is imaged towards the measuring instrument (5) and upon a rotation around the axis of rotation (10) close to the manipulation device towards the optical axis (11) the contact side (6), facing the component, of the contact device (8) is imaged towards the measuring instrument (5),
the optical axis (23) of the measuring instrument (5) fixedly or variably intersecting the centre axis (7), positioned perpendicularly in its centre point on the optical axis (11) between the manipulation device (2) and the contact device (8), roughly at the height of the optical axis (11) between the manipulation device (2) and the contact device (8) at an angle α, which lies in the range from -30° to +30°, and/or the optical axis (23) of the measuring instrument (5) running fixedly or variably parallel to the centre axis (7) and/or being congruent therewith.

2. A device for the targeted movement of electronic components (3), consisting of a manipulation device (2) for grasping, pivoting, displacing and/or rotating at least one electronic component (3) around and/or along the x axis and/or y axis and/or z axis and for depositing said at least one electronic component (3),
- at least one area of deposit (8) on which the component (3) is to be positioned,
- an optical axis (11), which extends horizontally, vertically or diagonally between the manipulation device (2) and the area of deposit (8),
- at least one mirror (20), which can be inserted completely or partially into the optical axis (11) between the manipulation device (2) and the area of deposit (8), this mirror (8) imaging the component (3) on the one hand and the area of deposit (6) on the other hand and the measuring field of the measuring instrument (5) measuring the mirror (20),
**characterised in that** the area of deposit is an electrical contact device (8) for producing an electrically conductive connection between an electronic component (3) to be tested and a testing device downstream from the contact device (8),
**in that** the mirror can pivot translationally and rotationally around a central axis of rotation (24), it being possible to displace the central axis of rotation (24) towards the optical axis (11) between the manipulation device (2) and the contact device (8) so that in its pivoted end positions the mirror (20) is situated completely or partially in the optical axis (11) between the manipulation device (2) and the contact device 3 (8), and the mirror (2) can image the contact side (4) of the component (3) grasped by the manipulation device (2) upon a rotation around the central axis of rotation (24) and can image the contact side (6) of the contact device (8) facing the component towards the measuring instrument (5) upon a rotation around the central axis of rotation (24) in the first end position into an opposite end position,
the optical axis (23) of the measuring instrument (5) fixedly or variably intersecting the centre axis (7), positioned perpendicularly in its centre point on the optical axis (11) between the manipulation device (2) and the contact device, (8) roughly at the height of the optical axis (11) between the manipulation device (2) and the contact device (8) at an angle α, which lies in the range from -30° to +30°, and/or the optical axis (23) of the measuring instrument (5) running fixedly or variably parallel to the centre axis (7) and/or being congruent therewith.

3. A device according to Claim 1,
**characterised in that** the mirror (20) is mounted for downward or upward rotation respectively around the axis of rotation (9) close to the contact device and the axis of rotation (10) close to the manipulation device in such a manner that the mirror (20) is able to pivot out of a horizontal starting position (0°) into the two end positions each of 45°, the mirror (20) in its substantially horizontal starting position being provided outside the optical axis (11) between the manipulation device (2) and the contact device (8) and if necessary substantially parallel to this optical axis (11), and at least in its respective 45° end positions protrudes completely or partially into the optical axis (11).

4. A device according to Claim 3,
**characterised in that** the mirror (20) can be pivoted out of a horizontal starting position (0°) into the two end positions each of 45° and in its substantially horizontal starting position is provided outside the optical axis (11) between the manipulation device (2) and the contact device (7) and if necessary substantially parallel to this optical axis, and further to a displacement of its central axis of rotation (24) towards the optical axis (11) and further to a partial rotation around the central axis of rotation (24) protrudes completely or partially into the optical axis (11) at least in its respective 45° end positions.

5. A device according to one or more of the preceding Claims,
**characterised in that** the mirror (20) comprises one or more markings (13) completely or partially perceptible by means of the measuring instrument (5), which markings serve for the calibration and the determination of the position and/or the alignment of the manipulation device (2), of the electronic components (2) grasped by the manipulation device (2) as well as the contact device (8) in relation to a device-specific coordinate system, these markings (13) being clearly assigned to the coordinate system of the device.

6. A device according to Claim 5,
**characterised in that** the markings (13) are provided in the edge regions and/or in the corner regions of the mirror (20).

7. A device according to Claim 5 or 6,
**characterised in that** a first pair (14) of markings (13) is situated on the centre axis (15, 24) running parallel and centrally to the axes of rotation (9, 10),
**in that** a second pair (16) of markings (13) is situated in the edge region of the mirror (20) close to the contact device
**and in that** a third pair (17) of markings (13) is situated in the edge region of the mirror close to the manipulation device, the distance between the marking (16) and the marking (17) of one side of the mirror having the length L and the distance between the markings (16) and (14) and between the markings (14) and (17) of one side of the mirror (20) in each case being L/2
**and in that** a fourth pair (18) of opposite markings is situated between the markings (16) and (14) and a fifth pair (19) of opposite markings is positioned between the markings (14) and (17), the distance between the markings (18) and (16) and also between the markings (18) and (14) on the one hand and between the markings (19) and (14) and also between the markings (19) and (17) on the other hand in each case being L/4.

8. A device according to Claim 7,
**characterised in that** the distance L between the markings (17) and (16) of the same side of the mirror (20) is in the range from 50 mm to 200 mm.

9. A device according to one of Claims 5 to 8,
**characterised in that** the distance L between the markings (17 and (16) of the same side of the mirror (20) is in the range from 30 mm to 150 mm.

10. A device according to one or more of Claims 5 to 9,
**characterised in that** the distance H between the markings (13) of one side of the mirror (20) and the opposite markings (13) of the other, opposite side of the mirror (20) is greater than the distance L/2 and is in the range from 51 mm to 500 mm.

11. A device according to one or more of the preceding Claims,
**characterised in that** the manipulation device (2) comprises a component holder (1) in the form of a gripper or sucker, which can be pivoted by 90° or 180° around an axis of rotation (21) running parallel to the contacting plane in such a manner that the component receiving surface of the component holder (1) can be oriented substantially parallel to the contact side (6) of the electrical contact device (8) .

12. A device according to one or more of the preceding Claims,
**characterised in that** the manipulation device (2) is adjustable for grasping, pivoting, displacing and/or rotating the electronic component (3) around and/or along the x axis and/or y axis and/or z axis and for depositing said electronic component (3) by means of an adjustment device along and/or around the x axis and/or y axis and/or z axis.

13. A device according to one or more of the preceding Claims,
**characterised in that** the adjustment device for adjusting the manipulation device (2) consists of two guide rails spaced parallel to each other and apart and a crossbeam extending at right angles to the longitudinal axis of the guide rails, which crossbeam is mounted for longitudinal displacement on the guide rails, on the front side towards the electrical contact device (8) on the crossbeam a plurality of manipulation devices (2) being displaceably and/or pivotally mounted along the x axis and/or the y axis and/or the z axis, and it being possible to perform these displacement or pivoting operations of the manipulation devices (2) dependently or independently of each other around identical or different axes.

14. A device according to one or more of the preceding Claims,
**characterised in that** it includes a temperature chamber inside which at least one section of a conveying means (22), an electrical contact device (8), a mirror (20) and at least one manipulation device (2) are provided for grasping, pivoting, displacing and/or rotating at least one electronic component (3) around and/or along the x axis and/or y axis and/or z axis and for depositing said at least one electronic component (3), the measuring instrument (5) and the drive means being provided to move the conveying means and/or the manipulation device (2) and/or the adjustment device outside the temperature chamber.

15. A device according to one or more of the preceding Claims,
**characterised in that** it includes a conveying means (22) for moving electronic components (3) into or out of the temperature chamber.

16. A device according to one or more of the preceding Claims,
**characterised in that** it includes a central data processing unit, which communicates with a measuring instrument (5) and with a testing device downstream from the electrical contact device (8) on the one hand and the drive elements for driving the mirror (20) and/or the at least one manipulation device (2) and/or the adjustment device and/or the conveying means (22) on the other hand.

17. A device according to Claim 16,
**characterised in that** the central data processing unit contains a programmable microprocessor, which is designed such that it controls the drive of the mirror (20) only into a pivoted position when the at least partially withdrawn manipulation device (2) leaves the space required for pivoting, and which is also configured such that it determines from the measurement signals coming from the measuring instrument (5) the position and/or the angle of rotation as well as the geometric centre of area of the electronic component (3) to be moved, determines the deviations of the set-down site of the receiving surface of the component holder (1) on the electronic component (3) from its centre of area and establishes a correction signal compensating these deviations and transmits control variables to the drive means of the manipulation device (2) and/or of the adjustment device, which control variables are supplied with the correction signals for fine adjustment, these control variables fundamentally being determined by the place and position of the electronic component (3) to be grasped or grasped, the place and position of the electrical contact device (8) and the position and location of the set-down site corresponding to the respective quality category,
and the microprocessor outputting these control variables to the drive means of the manipulation device (2) and the adjustment device in such a manner that the electronic component (3) grasped by means of the component holder (1) firstly comes into precisely fitting engagement with the electrical contact device (9) by a contact pressure sufficient for the measurement and, subsequent to the measurement, the component holder (1) charged with the electronic component (3) swivels downward from the horizontal or vertically upward pointing measurement position and deposits the electronic component (3) on the conveying means (22) to be transported away in dependence upon the test result and sorted by quality category.

18. A device according to Claim 16 or 17,
**characterised by** a mechanical or a contactless optical, electric, capacitive or inductive measuring instrument, the field of vision of which is directed substantially completely or partially onto the mirror (20), the measuring instrument (5) communicating with the data processing unit and by means thereof with the drive elements of the mirror (20) and/or of the conveying means (22) and/or of the manipulation device (2) and/or of the adjustment device.

19. A device according to Claim 18,
**characterised by** an optical measuring instrument with an entocentric lens or with a telecentric lens.

20. A device according to Claim 4,
**characterised in that** a coaxial shaft arrangement (25) with two shafts (26, 27) that can freely rotate in opposite directions is mounted on one side or on either side of the mirror (20),
**in that** each shaft (26, 27) bears in a U shape a pair of swivelling levers (30, 31; 32, 33) that are of different lengths and act indirectly or directly on opposite edge regions (28, 29) of the mirror (20), the different lengths of the two swivelling levers (30, 31; 32, 33) belonging to the same shaft (26, 27) being chosen such that an imaginary line (34, 35) through the free ends of the respectively interacting swivelling levers (30, 31; 32, 33) intersects an imaginary extension of the coaxial shaft arrangement at an angle of 45° in each case, and the swivelling of the one pair of swivel levers (30, 31) towards the optical axis (11) between the manipulation device (2) and the electrical contact device (8) resulting in a lowering of the mirror (20) into the region of the optical axis (11) and in an inclination of the mirror (20) into a first 45° end position, whereas the swivelling of the other pair of swivelling levers (32, 33) towards the optical axis (11) between the manipulation device (2) and the electrical contact device (8) results in a lowering of the mirror (20) into the region of the optical axis (11) and also an inclination of the mirror (20) into an opposite second 45° end position.

## Revendications

1. Dispositif pour déplacer de manière ciblée des composants électroniques (3), comprenant une installation de manipulation (2) pour recevoir, pivoter, coulisser et/ou tourner autour et/ou le long de l'axe x et/ou y et/ou z ainsi que pour déposer au moins un composant électronique (3),
- au moins un dépôt sur lequel on positionne le composant,
- un axe optique (11) qui s'étend horizontalement, verticalement ou en position inclinée entre l'installation de manipulation (2) et le dépôt (8),
- au moins un miroir (20) qui se glisse totalement ou partiellement dans l'axe optique (11) entre l'installation de manipulation (2) et le dépôt (8), ce miroir donnant d'une part l'image du composant (3) et d'autre part celle du dépôt (6) et le champ de mesure du dispositif de mesure saisit le miroir (20),
**caractérisé en ce que**
le dépôt comporte une installation de contact électrique (8) pour réaliser une liaison électroconductrice entre un composant électronique (3) à contrôler et une installation de vérification en aval de l'installation de contact (8),
le miroir (20) peut tourner autour d'un axe de rotation (9) du côté de l'installation de contact et d'un axe de rotation (10) du côté de l'installation de manipulation de façon que pour une rotation autour de l'axe de rotation (9) côté installation de contact, en direction de l'axe optique (11) passant entre l'installation de manipulation (2) et l'installation de contact (8), le côté contact (4) du composant (3) pris par l'installation de manipulation (2) et pour une rotation autour de l'axe de rotation (10) côté installation de manipulation, en direction de l'axe optique (11), donne l'image du côté contact (6) vers le composant de l'installation de contact (8) en direction de l'installation de mesure (5),
l'axe optique (23) de l'installation de mesure (5) coupe l'axe central (7) perpendiculaire à l'axe optique (11) entre l'installation de manutention (2) et l'installation de contact (8), perpendiculairement en son milieu, sensiblement à hauteur de l'axe optique (11), entre l'installation de manipulation (2) et l'installation de contact (8), de façon fixe ou variable sous un angle (α) situé dans une plage comprise entre -30° et +30° et/ou l'axe optique (23) du dispositif de mesure (5) est fixe ou variable parallèlement à l'axe central (7) et/ou coïncide avec celui-ci.

2. Dispositif de déplacement ciblé de composants électroniques (3), comprenant une installation de manipulation (2) pour recevoir, pivoter, coulisser et/ou tourner autour et/ou le long de l'axe x et/ou y et/ou z ainsi que pour déposer au moins un composant électronique (3),
- au moins un dépôt (8) sur lequel se positionne le composant (3),
- un axe optique (11) qui s'étend entre l'installation de manipulation (2) et le dépôt (8) suivant une direction horizontale, verticale ou inclinée,
- au moins un miroir (20) qui se glisse totalement ou partiellement dans l'axe optique (11) entre l'installation de manipulation (2) et le dépôt (8), ce miroir (20) donnant d'une part une image du composant (3) et d'autre part du dépôt (6) et le champ de mesure du dispositif de mesure (5) saisit le miroir (20),
**caractérisé en ce que**
le dépôt est une installation de contact électrique (8) pour réaliser une liaison électroconductrice entre un composant électronique (3) à vérifier et une installation de vérification en aval de l'installation de contact (8),
le miroir peut être basculé en translation ou en rotation autour d'un axe de rotation central (24),
l'axe de rotation central (24) étant réglable en direction de l'axe optique (11), entre l'installation de manipulation (2) et l'installation de contact (8) suffisamment pour que le miroir (20) dans ses positions de fin de course, basculé, se trouve totalement ou partiellement dans l'axe optique (11), entre l'installation de manipulation (2) et l'installation de contact (8) et pour une rotation autour de l'axe de rotation central (24) le miroir (20) donne dans sa première position de fin de course basculée du côté contact (4) du composant (3) reçu par l'installation de manipulation (2) et pour une rotation autour de l'axe de rotation central (24) dans la position de basculement, opposée, le côté contact (6) du côté du composant dans l'installation de contact (8), donne une image dans la direction du dispositif de mesure (5),
l'axe optique (23) du dispositif de mesure (5) coupant l'axe optique (11) entre l'installation de manipulation (2) et l'installation de contact (8), en son milieu, perpendiculairement à l'axe central (7), debout, sensiblement à hauteur de l'axe optique (11) entre l'installation de manipulation (2) et l'installation de contact (8), de façon rigide ou variable sous un angle (α) compris dans une plage entre -30° et + 30° et/ou l'axe optique (23) du dispositif de mesure (5) est fixe ou variable parallèlement à l'axe central (7) et/ou coïncide avec celui-ci.

3. Dispositif selon la revendication 1,
**caractérisé en ce que**
le miroir (20) est monté pivotant respectivement vers le bas ou vers le haut autour d'un axe de rotation (9) du côté de l'installation de contact et de l'axe de rotation (10) du côté de l'installation de manipulation de façon à pouvoir basculer le miroir (20) d'une position horizontale de repos (0°) dans l'une des deux positions de fin de course, correspondant chaque fois à 45°, le miroir (20) occupant sa position de repos essentiellement horizontale, au-delà de l'axe optique (11), entre l'installation de manipulation (2) et l'installation de contact (8) et le cas échéant pratiquement parallèle à cet axe optique (11) et au moins dans ses positions de fin de course respectives à 45°, il pénètre totalement ou partiellement dans l'axe optique (11).

4. Dispositif selon la revendication 3,
**caractérisé en ce que**
le miroir (20) peut pivoter de sa position de repos horizontale (0°) dans l'une des deux positions de fin de course respectives à 45°, et dans l'une de ses positions de repos, essentiellement horizontale, en dehors de l'axe optique (11), entre l'installation de manipulation (2) et l'installation de contact (8) et le cas échéant essentiellement parallèlement à cet axe optique (11) et du fait du coulissement de son axe central (24) dans la direction de l'axe optique (11) ainsi que du fait de sa rotation partielle autour de l'axe de rotation central (24), au moins dans ses positions de fin de course respectives à 45° il pénètre totalement ou partiellement dans l'axe optique (11).

5. Dispositif selon une ou plusieurs des revendications précédentes,
**caractérisé en ce que**
le miroir (20) comporte un ou plusieurs marquages (13) perçus totalement ou partiellement par le dispositif de mesure (5), qui servent au calibrage et à la détermination de la position et/ou de l'alignement de l'installation de manipulation (2), des composants électroniques (3) portés par l'installation de manipulation (2) ainsi que de l'installation de contact (8) par rapport à un système de coordonnées spécifique au dispositif, ces marquages (13) étant associés de manière univoque au système de coordonnées du dispositif.

6. Dispositif selon la revendication 5,
**caractérisé en ce que**
les marquages (13) sont prévus dans les zones des bords et/ou des zones des coins du miroir (20).

7. Dispositif selon la revendication 5 ou 6,
**caractérisé en ce qu'**
une première paire (14) de marquages (13) se trouve sur l'axe central (15, 24) parallèle et au milieu des axes de rotation (9, 10),
une seconde paire (16) de marquages (13) se trouve dans la zone de bord côté installation de contact du miroir (20) et
une troisième paire (17) de marquages (13) se trouve dans la zone de bord du miroir côté installation de manipulation,
la distance entre les marquages (16) et les marquages (17) d'un côté du miroir correspondant à la longueur (L) et la distance entre les marquages (16) et (14) ainsi qu'entre les marquages (14) et (17) d'un côté du miroir (20) correspond chaque fois à (L/2) et
une quatrième paire (18) de marquages opposée se situe entre les marquages (16) et (14) et une cinquième paire (19) de marquages opposée se situe entre les marquages (14) et (17),
la distance, d'une part, entre les marquages (18) et (16) et les marquages (18) et (14) ainsi que d'autre part entre les marquages (19) et (14) et entre les marquages (19) et (17), est chaque fois égale à (L/4).

8. Dispositif selon la revendication 7,
**caractérisé en ce que**
la distance (L) entre les marquages (17) et (16) du même côté du miroir (20) se situe dans une plage comprise entre 50 mm et 200 mm.

9. Dispositif selon l'une des revendications 5 à 8,
**caractérisé en ce que**
la distance (L) entre les marquages (17) et (16) du même côté du miroir (20) se situe dans une plage comprise entre 30 mm et 150 mm.

10. Dispositif selon une ou plusieurs des revendications 5 à 9,
**caractérisé en ce que**
la distance (H) entre les marquages (13) d'un côté du miroir (20) et les marquages (13), de l'autre côté, opposés au miroir (20) est supérieure à la distance (L/2) et se situe dans une plage comprise entre 51 mm et 500 mm.

11. Dispositif selon l'une ou plusieurs des revendications précédentes,
**caractérisé en ce que**
l'installation de manipulation (2) comporte un support de composant (1) sous la forme d'une pince ou d'une tête aspirante qui peut pivoter de 90° ou de 180° autour d'un axe de rotation (21) parallèle au plan de contact,
la surface de réception du composant du support de composant (1) peut être alignée pratiquement parallèlement au côté de contact (6) de l'installation de contact électrique (8).

12. Dispositif selon l'une ou plusieurs des revendications précédentes,
**caractérisé en ce que**
l'installation de manipulation (2) est réglable pour recevoir, pivoter, coulisser et/ou tourner autour et/ou le long de l'axe x et/ou de l'axe y et/ou de l'axe z ainsi que pour déposer le composant électronique (3), par l'intermédiaire d'une installation de réglage le long et/ou autour de l'axe x et/ou de l'axe y et/ou de l'axe z.

13. Dispositif selon l'une ou plusieurs des revendications précédentes,
**caractérisé en ce que**
l'installation de réglage de l'installation de manipulation (2) se compose de deux rails de guidage, parallèles, écartés l'un de l'autre, et d'une traverse perpendiculaire à l'axe longitudinal des rails de guidage, cette traverse étant montée de manière coulissante longitudinalement sur les rails de guidage,
et du côté frontal, en direction de l'installation de contact électrique (8), la traverse comporte un grand nombre d'installations de manipulation (2) coulissant et/ou pivotant par rapport à l'axe x et/ou l'axe y et/ou l'axe z et
ces mouvements de coulissement ou de pivotement des installations de manipulation (2) se faisant autour d'axes identiques ou différents, de manière dépendante ou indépendante.

14. Dispositif selon l'une ou plusieurs des revendications précédentes,
**caractérisé en ce qu'**
il comprend une chambre de mise en température recevant au moins un segment d'un moyen de transfert (22), une installation de contact électrique (8), un miroir (20) ainsi qu'au moins une installation de manipulation (2), pour recevoir, pivoter, coulisser et/ou tourner autour et/ou le long de l'axe x et/ou de l'axe y et/ou de l'axe z ainsi que pour déposer au moins un composant électronique (3),
le dispositif de mesure (5) et les moyens d'entraînement pour le moyen de transfert et/ou l'installation de manipulation (2) et/ou l'installation de réglage étant extérieurs à la chambre de mise en température.

15. Dispositif selon l'une ou plusieurs des revendications précédentes,
**caractérisé en ce qu'**
il comporte un moyen de transfert (22) pour introduire ou extraire les composants électroniques (3) de la chambre de mise en température.

16. Dispositif selon l'une ou plusieurs des revendications précédentes,
**caractérisé en ce qu'**
elle comprend une installation centrale de traitement de données, reliée d'une part à une installation de vérification en aval de l'installation de contact (8) et d'autre part aux éléments d'entraînement pour entraîner le miroir (20) et/ou au moins une installation de manipulation (2) et/ou de l'installation de réglage et/ou du moyen de transfert (22).

17. Dispositif selon la revendication 16,
**caractérisé en ce que**
l'installation centrale de traitement de données comporte un microprocesseur programmable réalisé pour commander l'entraînement du miroir (20) seulement dans une position de basculement rentrant si l'installation de manipulation (2), au moins en partie rétractée, libère l'espace pour ce basculement rentrant et il est en outre conçu pour déterminer à partir des signaux de mesure venant du dispositif de mesure (5), la position et/ou l'angle de rotation ainsi que le centre de gravité de la surface géométrique du composant électronique (3) à déplacer, pour déterminer les écarts de l'emplacement de dépose de la surface de réception du support de composant (1) sur le composant électronique (3) par rapport à son centre de gravité de surface et déterminer un signal de correction pour compenser de tels écarts et de transmettre des grandeurs de réglage au moyen d'entraînement de l'installation de manipulation (2) et/ou de l'installation de réglage, grandeurs chargées de signaux de correction pour un réglage fin,
ces grandeurs de réglage étant déterminées en principe par l'emplacement et la position du composant électronique (3) à prendre ou pris, de l'emplacement et de la position de l'installation de contact électrique (8) ainsi que de la position et de la situation de l'emplacement de dépôt correspondant à la classe de qualité respective et
le microprocesseur émet ces grandeurs de réglage pour les moyens d'entraînement de l'installation de manipulation (2) et de l'installation de réglage de façon que le composant électronique (3) reçu par le support de composant (1) arrive tout d'abord en prise de manière ajustée, avec une pression d'application suffisante pour la mesure, avec l'installation de contact électrique (8) et le support de composant (1) chargé du composant électronique (3) est, à la suite de la mesure, déplacé à partir de sa position de mesure horizontale ou verticale tournée vers le haut, pour être basculé vers le bas et en fonction du résultat du contrôle, le composant électrique (3) est classé dans une classe de qualité pour être déposé sur le moyen de transfert (22) qui l'évacue.

18. Dispositif selon la revendication 16 ou 17,
**caractérisé par**
un dispositif de mesure mécanique ou optique, électrique, capacitif ou inductif, sans contact, et dont le champ d'observation est principalement dirigé totalement ou partiellement sur le miroir (20),
le dispositif de mesure (5) étant relié à l'installation de traitement de données et par celle-ci, aux éléments d'entraînement du miroir (20) et/ou du moyen de transfert (22) et/ou de l'installation de manipulation (2) et/ou de l'installation de réglage.

19. Dispositif selon la revendication 18,
**caractérisé par**
un dispositif de mesure optique comportant un objectif endocentrique ou un objectif télécentrique.

20. Dispositif selon la revendication 4,
**caractérisé par**
un dispositif d'arbres coaxiaux (25) d'un côté ou des deux côtés du miroir (20), avec deux arbres (26, 27) tournant librement l'un par rapport à l'autre,
chaque arbre (26, 27) portant une paire de leviers de pivotement (30, 31 ; 32, 33) de longueurs différentes, agissant directement ou indirectement sur les zones de bords (28, 29) opposés du miroir (20), les longueurs différentes des deux leviers de pivotement (30, 31 ; 32 , 33) appartenant au même arbre (26, 27) étant choisies pour qu'une ligne géométrique passant par les extrémités libres des leviers pivotants (30, 31 ; 32, 33) qui coopèrent, coupe le prolongement géométrique du dispositif d'arbre coaxial (25) suivant un angle respectif de 45° et
par le pivotement d'une paire de leviers pivotants (30, 31) en direction de l'axe optique (11) entre le dispositif de manipulation (2) et l'installation de contact électrique (8) abaisse le miroir (20) dans la zone de l'axe optique (11) et on l'incline dans une première position de fin de course à 45° alors que le basculement de l'autre paire de leviers pivotants (32, 33) en direction de l'axe optique (11) reliant le dispositif de manipulation (2) et l'installation de contact électrique (8), se traduit par l'abaissement du miroir (20) dans la zone de l'axe optique (11) et à l'inclinaison du miroir (20) dans la seconde position de fin de course à 45°, opposée à la précédente.
